# EUROPEAN PATENT SPECIFICATION

(11) **EP 1 017 070 B1**
(45) Date of publication and mention of the grant of the patent: **08.03.2006**
(21) Application number: 99125562.1
(22) Date of filing: 21.12.1999
(51) Int. Cl.: H01G 9/20

(54) **Photo-electrochemical cell**
Photoelektrochemische Zelle
Cellule photoélectochimique

(30) Priority: 28.12.1998 JP 37378298; 19.08.1999 JP 23274399
(43) Date of publication of application: 05.07.2000
(73) Proprietor: FUJI PHOTO FILM CO., LTD., Minami-Ashigara-shi, Kanagawa-ken (JP)
(72) Inventor: Watanabe, Tetsuya, Ashigara-shi, Kanagawa (JP); Takizawa, Hiroo, Ashigara-shi, Kanagawa (JP); Okazaki, Masaki, Ashigara-shi, Kanagawa (JP)
(74) Representative: Grünecker, Kinkeldey, Stockmair & Schwanhäusser Anwaltssozietät

(56) References cited:
- EP-A- 0 924 724
- AU-A- 7 312 598
- ZHAO W ET AL: "Interaction of squarylium cyanine with nanoparticle TiO2 for photoelectric conversion" DYES AND PIGMENTS, ELSEVIER APPLIED SCIENCE PUBLISHERS. BARKING, GB, vol. 39, no. 4, 1 December 1998 (1998-12-01), pages 281-290, XP004144760 ISSN: 0143-7208
- SUNG H K ET AL: "Syntheses, Characteristics and Electrophotographic Properties of New Dithiosquarylium Dyes" DYES AND PIGMENTS, ELSEVIER APPLIED SCIENCE PUBLISHERS. BARKING, GB, vol. 39, no. 2, 1 September 1998 (1998-09-01), pages 77-87, XP004138492 ISSN: 0143-7208
- TERPETSCHNIG E ET AL: "SYNTHESIS AND CHARACTERIZATION OF UNSYMMETRICAL SQUARAINES: A NEW CLASS OF CYANINE DYES" DYES AND PIGMENTS, ELSEVIER APPLIED SCIENCE PUBLISHERS. BARKING, GB, vol. 21, no. 3, 1993, pages 227-234, XP000372882 ISSN: 0143-7208

## Description

### FIELD OF THE INVENTION

This invention relates to a photoelectric device and, more particularly, a photoelectric conversion device using dye-sensitized semiconductor fine particles.

### BACKGROUND OF THE INVENTION

Study of photovoltaic power generation has been directed chiefly to development of single-crystalline silicon solar cells, polycrystalline silicon solar cells, amorphous silicon solar cells, and compound solar cells using cadmium telluride, copper indium selenide, etc. It is required for spread of solar cells to overcome such difficulties as a high production cost, a short supply of raw materials, and a long energy payback time. Although many solar cells using organic materials have been proposed aiming at an increase of working area and a reduction of cost, they have a low conversion efficiency and poor durability.

Under these circumstances, *Nature,* vol. 353, pp. 737-740 (1991) and U.S. Patent 4,927,721 disclosed a photoelectric conversion device using dye-sensitized semiconductor fine particles, a solar cell comprising the device, and materials and techniques for producing them. The proposed cell is a wet type solar cell comprising a porous thin film of titanium dioxide spectrally sensitized by a ruthenium complex. A primary advantage of this system is that an inexpensive oxide semiconductor, such as titanium dioxide, can be used without being highly purified so that a photoelectric conversion device can be provided at a reduced cost. A secondary advantage is that the sensitizing dye used shows a broad absorption spectrum so that light in almost the whole wavelength region of visible light can be converted to electricity.

One of the problems of conventional dye-sensitized photoelectric conversion devices that wait for solution resides in use of an expensive ruthenium complex dye as a sensitizer. Development of a photoelectric conversion device sensitized by an inexpensive organic dye has been demanded. A photoelectric conversion device having semiconductor particles sensitized by a dye with e.g. squarylium, cyanine or phthalocyanine structure is described in document AU 7 312 598 A. Use of organic dyes for sensitizing photoelectric conversion devices are taught in Chemistry *Letters,* pp. 753-754 (1998) and the literature referred to therein, but the photoelectric conversion efficiency achieved with the known compounds is not sufficiently high, and the conversion to electricity is not always possible in the whole wavelength region.

### SUMMARY OF THE INVENTION

An object of the present invention is to provide a dye-sensitized photoelectric conversion device and a photo-electrochemical cell using the same which are inexpensive and have high photoelectric conversion efficiency by using an organic dye capable of efficiently sensitizing semiconductor fine particles.

The above object is accomplished by:
1) A photoelectric conversion device having the features defined in claim 1.
2) A photo-electrochemical cell defined by the features of claim 6, comprising the above-described photoelectric conversion device.

According to the present invention there are provided a dye-sensitized photoelectric conversion device and a photo-electrochemical cell which have excellent photoelectric characteristics at a low cost.

### BRIEF DESCRIPTION OF DRAWING

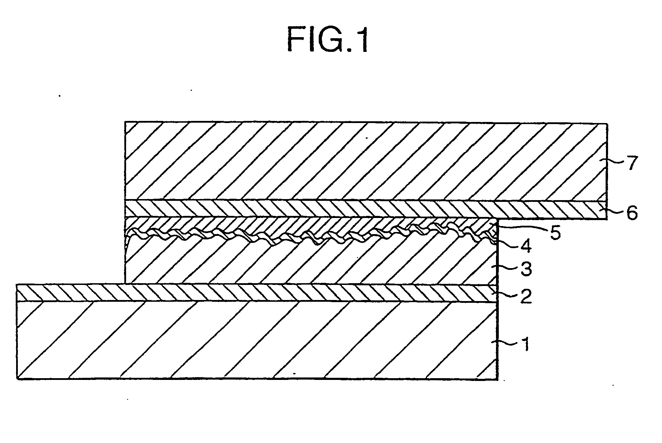

Fig. 1 is a cross section of the photo-electrochemical cell prepared in the example.

### DETAILED DESCRIPTION OF THE INVENTION

In formula (I), Q represents an atomic group necessary to complete a 5- or 6-membered nitrogen-containing heterocyclic ring which may be a condensed ring and may have a substituent. Examples of preferred heterocyclic rings completed by Q include benzothiazole, benzoxazole, benzoselenazole, benzotellurazole, 2-quinoline, 4-quinoline, benzimidazole, thiazoline, indolenine, oxadiazole, thiazole, and imidazole nuclei. Preferred of them are benzothiazole, benzoxazole, benzimidazole, benzoselenazole, 2-quinoline, 4-quinoline, and indolenine nuclei. Particularly preferred of them are benzothiazole, benzoxazole, 2-quinoline, 4-quinoline, and indolenine nuclei. The substituent that may be present on the ring includes a carboxyl group, a phospho group, a sulfo group, a halogen atom (i.e., F, Cl, Br or I), a cyano group, an alkoxy group (e.g., methoxy, ethoxy or methoxyethoxy), an aryloxy group (e.g., phenoxy), an alkyl group (e.g., methyl, ethyl, cyclopropyl, cyclohexyl, trifluoromethyl, methoxyethyl, allyl or benzyl), an alkylthio group (e.g., methylthio or ethylthio), an alkenyl group (e.g., vinyl or 1-propenyl), and an aryl group (e.g., phenyl, thienyl, toluyl or chlorophenyl).

The ring completed by Z is represented by formula (III) : 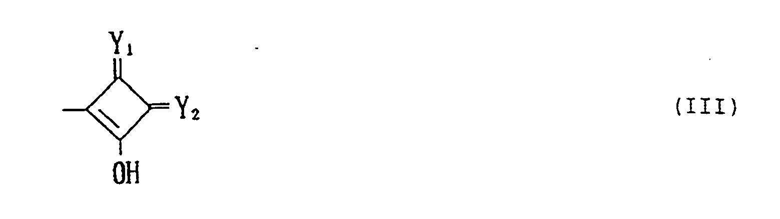
wherein Y₁ and Y₂ each represent an oxygen atom, a sulfur atom or C(CN)R''; and R" represents a cyano group, a carboxyl group, a carboxylic ester group or a carbonamido group.

In formula (III), Y₁ is preferably an oxygen atom. It is still preferred that Y₁ and Y₂ both represent an oxygen atom.

L₁, L₂, L₃, L₄, and L₅ each represents a substituted or unsubstituted methine group. Examples of the substituent on the methine group includes a substituted or unsubstituted alkyl group (preferably an alkyl group having 1 to 12, particularly 1 to 7, carbon atoms, such as methyl, ethyl, propyl, isopropyl, cyclopropyl, butyl, 2-carboxyethyl or benzyl), a substituted or unsubstituted aryl group (preferably an aryl group having 6 to 10 carbon atom, particularly 6 to 8 carbon atoms, e.g., phenyl, toluyl, chlorophenyl or o-carboxyphenyl), a heterocyclic group (e.g., pyridyl, thienyl, furanyl, pyridyl or barbituric acid), a halogen atom (e.g., chlorine or bromine), an alkoxy group (e.g., methoxy or ethoxy), an amino group (preferably an amino group having 1 to 12, particularly 6 to 12, carbon atoms, e.g., diphenylamino, methylphenylamino or 4-acetylpiperazin-l-yl), and an oxo group. The substituents on the methine group may be connected to each other to form such a ring as a cyclopentene ring, a cyclohexene ring or a squarylium ring. The substituent can form a ring together with an auxochrome.

n₁ represents an integer of from 0 to 4, preferably 0 to 3. n₂ represents 0 or 1.

R represents a substituent, preferably a substituted or unsubstituted aromatic group or a substituted or unsubstituted aliphatic group. The aromatic group preferably has 1 to 16, particularly 5 or 6, carbon atoms, and the aliphatic group preferably has 1 to 10, particularly 1 to 6, carbon atoms. Examples of the unsubstituted aliphatic and aromatic groups include methyl, ethyl, n-propyl, n-butyl, phenyl, and naphthyl group.

W represents a counter ion necessary to neutralize the charge quantity. Whether a dye is cationic or anionic or whether or not it has a net ionic charge depends on its auxochrome and substituent. Where a dye carries a dissociating group, it can dissociate to possess a negative charge. In this case, too, the total amount of charges is neutralized with W. Typical cations include inorganic or organic ammonium ions (e.g., tetraalkylammonium ion and pyridinium ion) and alkali metal ions. Anions, which may be either organic or inorganic, include halide ions (e.g., fluoride, chloride, bromide or iodide ions), substituted arylsulfonate ions (e.g., p-toluenesulfonate ion or p-chlorobenzenesulfonate ion), aryldisulfonate ions (e.g., 1,3-benzenedisulfonate ion, 1,5-naphthalenedisulfonate ion, and 2,6-naphthalenedisulfonate ion), alkylsulfate ions (e.g., methylsulfate ion) , a sulfate ion, a thiocyanate ion, a perchlorate ion, a tetrafluoroborate ion, a picrate ion, an acetate ion, and a trifluoromethanesulfonate ion.

W, as a charge balancing counter ion, may be an ionic polymer or a dye having an opposite charge. A metal complex ion (e.g., bisbenzene-1,2-dithiolatonickel (III)) also serves as W.

In formula (II), Q' has the same meaning as Q. Preferably, Q' represents an atomic group necessary to complete a 5-membered nitrogen-containing heterocyclic ring which may be a condensed ring and may have a substituent. Examples of preferred heterocyclic ring completed by Q' include a pyrrole ring, an imidazole ring and a triazole ring (1,2,3-triazole ring). Z' has the same meaning as Z. L₆, L₇, L₈, L₉, and L₁₀ each have the same meaning as L₁, L₂, L₃, L₄, and L₅. n₃ has the same meaning as n_{1,} n₄ has the same meaning as n₂. R' has the same meaning as R. W' has the same meaning as W.

The compounds S-1 to S-30 shown below are non-limiting examples of the compounds (i.e., the dye) represented by formula (I) or (II).

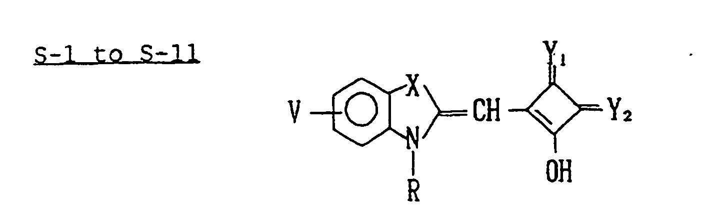

| Compound No. | X | V | R | Y₁ | Y₂ |
|---|---|---|---|---|---|
| S-1 | C(CH₃)₂ | 4,5-benzo | C₃H₇ | O | O |
| S-2 | C(CH₃)₂ | H | (CH₃)₂COOH | O | O |
| S-3 | C(CH₃)₂ | 4,5-benzo | C₂H₅ | S | S |
| S-4 | C(CH₃)₂ | 4,5-benzo | C₂H₅ | C(CN)₂ | O |
| S-5 | C(CH₃)₂ | 4, 5-benzo | C₂H₅ | C(CN)₂ | C(CN)₂ |
| S-6 | S | H | C₇H₅ | O | O |
| S-7 | S | 5,6-benzo | CH₃ | O | O |
| S-8 | O | H | CH₃ | O | O |
| S-9 | Se | H | CH₃ | O | O |
| S-10 | NC₂H₅ | H | CH₃ | O | O |
| S-11 | -CH=CH- | H | C₂H₅ | 0 | 0 |

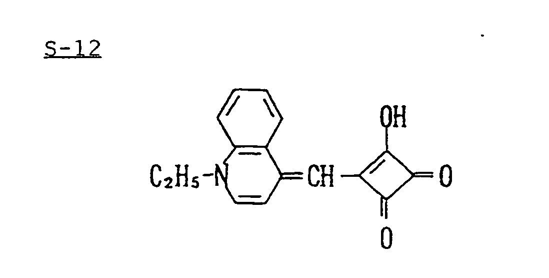

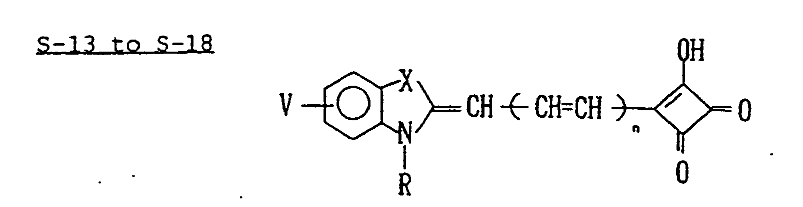

| Compound No. | X | V | R | n |
|---|---|---|---|---|
| S-13 | C(CH₃)₂ | H | CH₃ | 1 |
| S-14 | C(CH₃)₂ | 4,5-benzo | C₂H₅ | 1 |
| S-15 | S | H | CH₃ | 2 |
| S-16 | S | 5,6-benzo | C₂H₅ | 3 |
| S-17 | S | 5,6-benzo | C₂H₅ | 4 |
| S-18 | S | H | CH₃ | 4 |

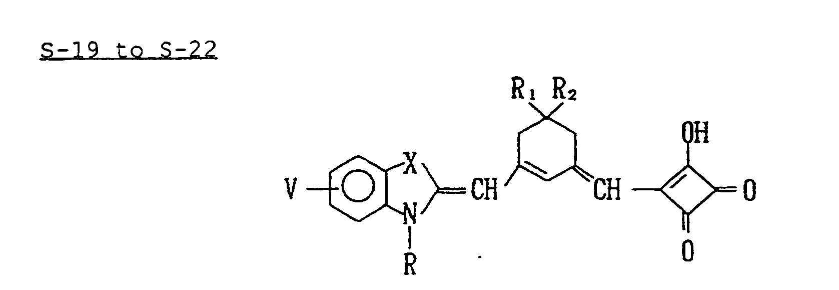

| Compound No. | X | R₁ | R₂ | R | V |
|---|---|---|---|---|---|
| S-19 | C (CH₃)₂ | CH₃ | CH₃ | C₂H₅ | H |
| S-20 | S | CH₃ | CH₃ | C₂H₅ | 6-CH₃ |
| S-21 | O | CH₃ | CH₃ | (CH₂)₃COOH | H |
| S-22 | O | Ph | H | C₂H₅ | 4,5-benzo |

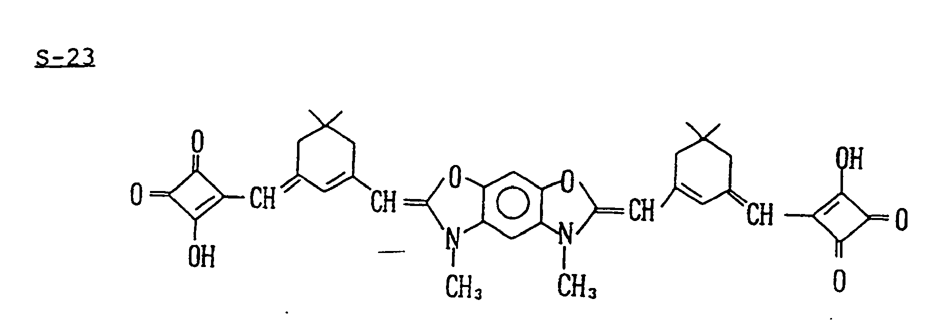

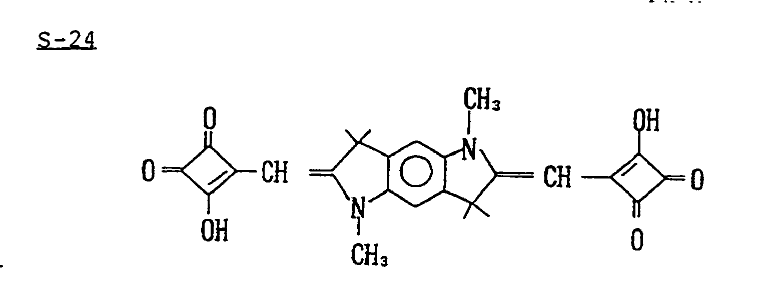

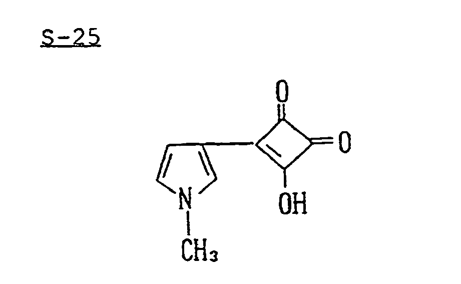

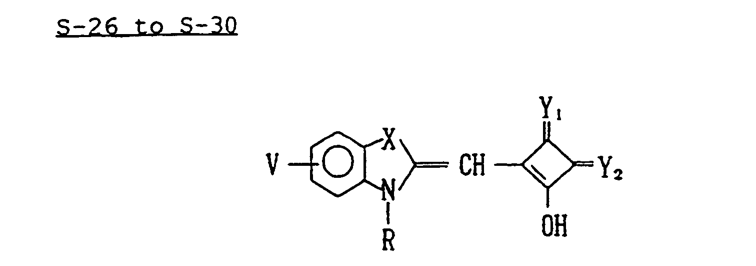

| Compound No. | X | V | R | Y₁ | Y₂ |
|---|---|---|---|---|---|
| S-26 | C(CH₃)₂ | 4,5-benzo | C₃H₇ | O | C(CN)COOH |
| S-27 | C(CH₃)₂ | H | CH₃ | (CN)COOH | C(CN)COOH |
| S-28 | S | 4,5-benzo | CH₃ | O | C (CN) COOC₂H₅ |
| S-29 | O | H | C₃H₇ | C ( CN ) COOH | C(CN)CONH₂ |
| S-30 | -CH=CH- | 5-CF₃ | C₂H₅ | O | C (CN) COOH |

The compounds of formula (I) or (II) are synthesized with reference to the teaching disclosed, e.g., in *Dyes and Pigments,* vol. 21, pp. 227-234. Synthesis Examples are shown below.

### SYNTHESIS EXAMPLE 1

### Synthesis of Compound S-1

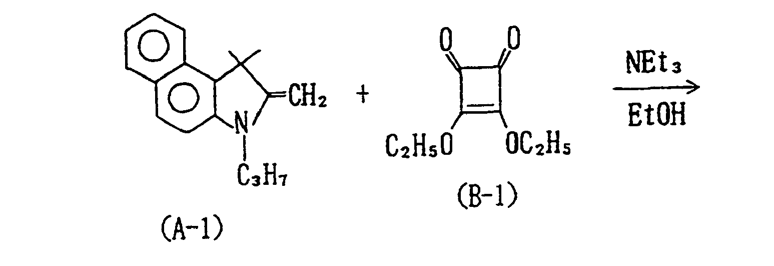

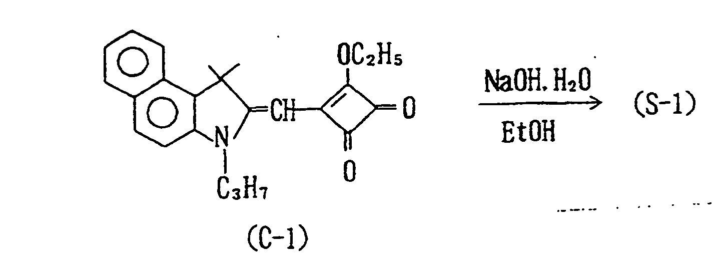

In a mixed solvent of 7 ml of ethanol and 1 ml of triethylamine was dissolved 1.2 g of compound (B-1) , and 1.9 g of compound (A-1) was added thereto while heat-refluxing the solution. The reaction mixture was cooled with ice, and the crystals formed were collected by filtration by suction and purified by column chromatography on Sephadex to obtain 2 g of compound (C-1). Two gram (2 g) of the compound (C-1) was added to 20 ml of ethanol, and 0.5 ml of 40% aqueous sodium hydroxide was added thereto, followed by heat-refluxing for 5 minutes. To the reaction mixture was added 7 ml of 2N hydrochloric acid under cooling with ice. The precipitated crystals were collected by filtration to obtain 1 g of S-1- λₘₐₓ = 440 nm (ε = 55000) (in methanol)

### SYNTHESIS EXAMPLE 2

### Synthesis of S-20

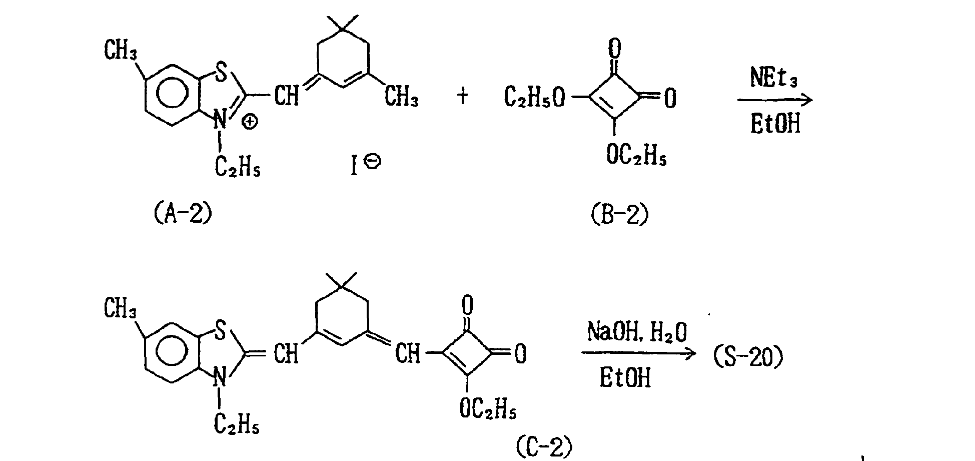

In 20 ml of ethanol were dissolved 2.2 g of compound (A-2) , 0.86 g of compound (B-2) , and 1 g of triethylamine, and the solution was heat-refluxed for 5 hours, followed by concentration. The residue was purified by silica gel column chromatography. The resulting compound (C-2) [0.87 g] was dissolved in 10 ml of ethanol, and 5 ml of 5% aqueous sodium hydroxide was added thereto, followed by heat-refluxing for 2 hours. Then, 7 ml of diluted hydrochloric acid was added thereto while cooling with ice, and the precipitated crystals were collected by filtration and washed with water to obtain 0.75 g of S-20. λₘₐₓ = 630 nm (ε = 120000) (in methanol)

The dye-sensitized photoelectric conversion device according to the invention comprises an electrically conductive substrate, a dye-sensitized semiconductor layer (photosensitive layer) provided on the conductive substrate, a charge transporting layer, and a counter electrode. The photo-electrochemical cell according to the present invention is a practical application of the photoelectric conversion device for use as a battery working in an external circuit.

The photosensitive layer is designed in conformity with the end use and may have either a single layer structure or a multilayer structure. Light having entered the photosensitive layer excites the dye. The excited dye has high energy electrons, which are handed over from the dye to the conduction band of the semiconductor fine particles and diffused to reach the conductive substrate. Meanwhile the dye molecules are converted into an oxidized state. In a photo-electrochemical cell, the electrons of the conductive substrate return to the oxidized dye through the counter electrode and the charge transporting layer thereby to regenerate the dye while working in the external circuit. The semiconductor film acts as a negative electrode of the cell. The layers constituting the device may be diffused and mixed mutually at their boundaries, for example, the boundary between the conductor layer (hereinafter described) of the conductive substrate and the photosensitive layer, the boundary between the photosensitive layer and the charge transporting layer, and the boundary between the charge transporting layer and the counter electrode.

The semiconductor serves as a photoreceptor that absorbs light to generate electrons and positive holes. In the dye-sensitized semiconductor, the task of light absorption and generation of electrons and positive holes is chiefly performed by the dye, and the semiconductor plays a role in accepting and transmitting the electrons.

Examples of the semiconductor which can be used in the present invention includes element semiconductors, e.g., Si or Ge, compound semiconductors, such as metal chalcogenides (e.g., oxides, sulfides, and selenides), and perovskite semiconductors. Examples of the metal chalcogenides include an oxide of titanium, tin, zinc, iron, tungsten, zirconium, hafnium, strontium, indium, cerium, yttrium, lanthanum, vanadium, niobium or tantalum; a sulfide of cadmium, zinc, lead, silver, antimony or bismuth; a selenide of cadmium or lead; and cadmium telluride. Examples of the other compound semiconductors include a phosphide of zinc, gallium, indium or cadmium, gallium arsenide, copper indium selenide, and copper indium sulfide. Examples of the perovskite semiconductors include strontium titanate, calcium titanate, sodium titanate, barium titanate, and potassium niobate.

Preferred semiconductors for use in the present invention include Si, TiO₂, SnO₂, Fe₂O₃, WO₃, ZnO, Nb₂O₅, CdS, ZnS, PbS, Bi₂S₃, CdSe, CdTe, GaP, InP, GaAs, CuInS₂, and CuInSe₂. Still preferred are TiO₂, ZnO, SnO₂, Fe₂O₃, WO₃, Nb₂O₅, CdS, PbS, CdSe, InP, GaAs, CuInS₂, and CuInSe₂. TiO₂ is the most preferred.

The semiconductor may be a single crystal or polycrystal. A single crystal is preferred for conversion efficiency, while a polycrystalline semiconductor is preferred from the standpoint of production cost, supply of raw materials, and an energy payback time. Finely particulate semiconductors having a particle size on the order of from nanometers to microns are particularly preferred. The semiconductor fine particles preferably have an average primary particle size of 5 to 200 nm, particularly 8 to 100 nm, in terms of a diameter of circle corresponding to a projected area of the particle (i.e., an equivalent circle diameter) . The semiconductor fine particles in a dispersed state (secondary particles) preferably have an average particle size of 0.01 to 100 µm.

Semiconductor fine particles of two or more kinds having different sizes may be used as a mixture. In this case, the average size of smaller particles is preferably 5 nm or less. For the purpose of scattering incident light to improve the rate of capturing light, large semiconductor particles of about 300 nm in size may be used in combination.

Examples of the electrically conductive substrate includes a substrate made of a conductive material, such as metal, and a nonconductive substrate made of glass or plastics having on the surface thereof a conductor layer. Examples of preferred conductors used for the conductor layer in the latter type of conductive substrates include metals (e.g., platinum, gold, silver, copper, aluminum, rhodium, and indium), carbon, and electrically conducting metal oxides (e.g., indium tin composite oxide and F-doped tin oxide) . The conductor layer preferably has a thickness of about 0.02 to 10 µm.

The conductive substrate preferably has as low a surface resistivity as possible. A desirable surface resistivity is 100 Ω/□ (square) or smaller, particularly 40 Ω/□ or smaller. While not limiting, the practical minimal surface resistivity is about 0.1 Ω/□.

It is preferred that the conductive substrate be substantially transparent to light. The term "substantially transparent" means that the light transmission is at least 10%, preferably 50% or more, still preferably 70% or more. A glass or plastic substrate having an electrically conductive metal oxide layer is preferred as a transparent substrate. Of the above conductive substrates particularly preferred is a conductive glass substrate obtained by depositing F-doped tin dioxide on a transparent substrate made of inexpensive soda-lime float glass. For use in an inexpensive flexible photoelectric conversion device or solar cell, a transparent polymer film having the above-described conductor layer is preferred. Examples of useful transparent polymers include tetraacetylcellulose (TAC), polyethylene terephthalate (PET), polyethylene naphthalate (PEN), syndiotactic polystyrene (SPS), polyphenylene sulfide (PPS), polycarbonate (PC), polyacrylate (PAR), polysulfone (PSF), polyester sulfone (PES), polyetherimide (PEI), cyclic polyolefins, and brominated phenoxy resins. The amount of the conductive metal oxide is preferably 0.01 to 100 g/m². The transparent conductive substrate is preferably used in such a manner that incident light enters from the side of the glass or plastic substrate.

The semiconductor fine particles are applied to the conductive substrate (or the conductor layer of the substrate) by, for example, a method comprising coating the conductive substrate with a dispersion or colloidal solution of the semiconductor fine particles or a sol-gel process comprising applying a precursor of the semiconductor fine particles onto the conductive substrate and hydrolyzing the precursor with moisture in air to form a particulate semiconductor film. A dispersion of the semiconductor fine particles is prepared by the above-mentioned sol-gel process, a method comprising grinding a semiconductor in a mortar, or a method comprising grinding a semiconductor in a mill. A synthetic semiconductor as precipitated in a solvent in the form of fine particles may also be used as such. Examples of useful dispersing media include water and various organic solvents, such as methanol, ethanol, isopropyl alcohol, dichloromethane, acetone, acetonitrile, and ethyl acetate. In preparing a dispersion, a polymer, a surface active agent, an acid, a chelating agent, and the like may be added as a dispersing aid if desired.

In general, as the thickness of the particulate semiconductor layer increases, the amount of the supported dye per unit projected area increases to show an increased rate of capturing light, but the distance of diffusion of generated electrons also increases, which results in an increased loss due to re-coupling of charges. Accordingly, there is a favorable thickness range for the particulate semiconductor layer, which is typically from 0.1 to 100 µm. Where the device is used as a photo-electrochemical cell, a more favorable thickness is 1 to 30 µm, particularly 2 to 25 µm. The amount of the semiconductor fine particles to be applied is preferably 0.5 to 400 g/m², still preferably 5 to 100 g/m².

It is preferred that the semiconductor particles applied to the substrate be heated to bring them into electronic contact with each other, to improve film strength, and to improve adhesion to the substrate. A preferred heating temperature is 40°C or higher and lower than 700°C, particularly from 100 to 600°C. The heating time is usually from 10 minutes to about 10 hours. Where a substrate having a low melting point or a softening point, such as a polymer film, is used, high-temperature treatment which would deteriorate the substrate should be avoided. Further, the heating temperature is preferably as low as possible for the economical consideration. The heating temperature can be lowered by using the above-mentioned small semiconductor fine particles having a diameter of 5 nm or less in combination or by conducting the heat treatment in the presence of a mineral acid.

For the purpose of increasing the surface area of the semiconductor fine particles and of increasing the purity in the vicinities of the semiconductor particles thereby to improve electron injection efficiency from the dye to the semiconductor particles, the heat-treated particulate semiconductor layer can be subjected to chemical plating using a titanium tetrachloride aqueous solution or electrochemical plating using a titanium trichloride aqueous solution.

It is preferable for the semiconductor fine particles to have a large surface area so that they may adsorb as large an amount of a dye as possible. The surface area of the semiconductor fine particles in the state applied to the conductive substrate is preferably 10 times or more, still preferably 100 times or more, the projected area. The practical upper limit of the surface area is, while not limited, about 1000 times the projected area.

Adsorption of the dye onto semiconductor fine particles is usually effected by immersing well-dried semiconductor fine particles in a dye solution for several hours at room temperature or, as described in JP-A-7-249790, while heat-refluxing. Dye adsorption may be carried out before, after or simultaneously with application of the semiconductor fine particles to the substrate, but it is preferably effected after the semiconductor application. where the applied semiconductor fine particles are to be subjected to the above-described heat treatment, dye adsorption is preferably conducted after the heat treatment. It is particularly preferred that the dye be adsorbed quickly before water is adsorbed to the surface of the heat-treated semiconductor layer. The unadsorbed dye is preferably removed by washing. The dyes may be used either individually or as a combination of two or more thereof. Where the dye-sensitized photoelectric conversion device is for a photo-electrochemical cell, the dyes to be combined can be selected so as to maximize the breadth of the wavelength region for photoelectric conversion.

In order to obtain a sufficient sensitizing effect, the dye or dyes are preferably present in an amount of 0.01 to 100 mmol per m² of the substrate and 0.01 to 1 mmol per gram of the semiconductor fine particles. With too small an amount of the dye, the sensitizing effect would be insufficient. If the dye is used in too large an amount, the non-adsorbed dye will float to reduce the sensitizing effect.

A colorless compound may be adsorbed together with the dye so as to lessen the interaction among dye molecules, such as association. Hydrophobic compounds such as carboxyl-containing steroid compounds (e.g., cholic acid) can be used for this purpose (i.e., a co-adsorption).

After dye adsorption, the surface of the semiconductor fine particles may be treated with an amine, such as pyridine, 4-t-butylpyridine or polyvinylpyridine. The amine may be used as such where it is liquid, or as dissolved in an organic solvent.

The charge transporting layer is a layer having a function of replenishing to an oxidized dye electrons. Typical charge transporting layers include a solution of a redox system dissolved in an organic solvent (i.e., an electrolytic solution), a gel electrolyte comprising a polymer matrix impregnated with a solution of a redox system dissolved in an organic solvent, and a molten salt containing a redox system. Solid electrolytes and hole-transporting materials are also useful.

Examples of electrolytes used in the present invention include combinations of I₂ and various iodides (for example, metal iodides, such as LiI, NaI, KI, CsI or CaI₂, and an iodine salt of a quarternary imidazolium compound, a quarternary pyridinium compound or a tetraalkylammonium compound); Br₂ and various bromides (for example, metal bromides, such as LiBr, NaBr, KBr, CsBr or CaBr₂, and a bromine salt of a quaternary ammonium compound, such as a tetraalkylammonium bromide or pyridinium bromide); combinations of metal complexes, such as a ferrocyananate-ferricyanate system or a ferrocene-ferricinium ion system; combinations of sulfur compounds, such as poly (sodium sulfite) and an alkylthiol-alkyl disulfide; combinations of an alkylviologen (such as methylviologen chloride, hexylviologen bromide, or benzylviologen tetrafluoroborate) and its reduction product; and combinations of a polyhydroxybenzene (e.g., hydroquinone or naphthohydroquinone) and its oxidation product; and the like. Preferred of them are combinations of I₂ and a metal iodide, such as LiI, NaI, KI, CsI or CaI₂, an iodine salt of a quarternary imidazolium compound, an iodine salt of a quarternary pyridinium compound or an iodine salt of a tetraalkylammonium compound.

It is preferred for the organic solvent used in the electrolytic solution to have a high boiling point so as to prevent deterioration due to volatilization. From the standpoint of the photoelectric conversion device performance, such as a short-circuit current density and conversion efficiency, it is also preferred for the solvent to have a low viscosity and a high dielectric constant. To have a low viscosity leads to an improvement in ion mobility. To have a high dielectric constant brings about an increase in effective carrier concentration Examples of suitable organic solvents include aprotic polar solvents, such as acetonitrile, propylene carbonate, ethylene carbonate, dimethylformamide, dimethyl sulfoxide, sulfolane, 1,3-dimethylimidazolinone, and 3-methyloxazolidinone. The polymer used as a matrix of a gel electrolyte includes polyacrylonitrile and polyvinylidene fluoride.

Since the redox system acts as an electron carrier, it should be present in a concentration above a certain level. A preferred concentration of the redox system in an electrolytic solution or in an impregnating solution used to prepare a gel electrolyte is 0.01 mol/l or higher, particularly 0.1 mol/l or higher, especially 0.3 mol/l or higher. While not limiting, the upper limit of the concentration is about 5 mol/l.

Examples of the molten salt includes a combination of lithium iodide and at least one other lithium salt (e.g., lithium acetate or lithium perchlorate). The flowability of the molten salt at room temperature can be increased by addition of a polymer, such as polyethylene oxide. Such a polymer can be added in a concentration of 1 to 50% by weight.

The hole-transporting material includes aromatic amines, polypyrrole, and polythiophene.

In a photo-electrochemical cell using the photoelectric conversion device, the counter electrode functions as a positive electrode. The counter electrode usually has a conductive substrate, such as those described above for use in the semiconductor electrode, but a substrate is not always required as far as sufficient strength is secured. For achieving air tightness, use of a substrate is advantageous, though.

At least one of the conductive substrate of the semiconductor electrode and the counter electrode must be substantially transparent so that incident light can reach the photosensitive layer. It is preferred for the photo-electrochemical cell of the present invention that the conductive substrate of the semiconductor electrode be transparent and that light be incident upon this side. In this case, it is preferred that the counter electrode has light-reflecting properties.

The counter electrode that can be used in photo-electrochemical cells includes glass or plastic having a metal or a conductive oxide deposited thereon. Metal can be deposited by vapor deposion, sputtering or a like technique for forming a metal thin film having a thickness of 5 µm or less, preferably 5 nm to 3 µm. A preferred counter electrode is a glass plate having platinum deposited thereon by vapor deposion or a metal thin film formed by vapor deposition or sputtering.

The photo-electrochemical cell of the invention may have its sides sealed with a polymer, an adhesive, etc. to prevent deterioration of constitution materials or volatilization of the volatile matter contained therein.

Preferred embodiments of the present invention are shown below.
(1) A photoelectric conversion device having semiconductor fine particles sensitized by a polymethine dye represented by formula (I) or (II).
(2) In formula (I) or (II), the ring completed by Z or Z' is represented by formula (III): 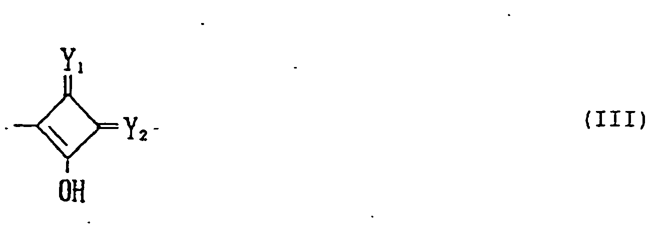
   wherein Y₁ and Y₂ each represent an oxygen atom, a sulfur atom or C(CN)R"; and R" represents a cyano group, a carboxyl group, a carboxylic ester group or a carbonamido group.
(3) In formula (III), Y₁ is an oxygen atom.
(4) In formula (III), Y₁ and Y₂ both represent an oxygen atom.
(5) In formula (I) or (II), the nitrogen-containing heterocyclic ring completed by Q or Q' is selected from the group consisting of an indolenine ring, a thiazoline ring, an oxazole ring, a selenazole ring, an imidazole ring, a 2-quinoline ring, a 4-quinoline ring or a condensed ring thereof having a benzene ring fused thereto.
(6) The semiconductor particles sensitized with the polymethine dye represented by formula (I) or (II) are titanium oxide fine particles.
(7) A photo-electrochemical cell comprising the photoelectric conversion device according to any one of the above-described preferred embodiments of the invention.

### EXAMPLE

The present invention will now be illustrated in greater detail with reference to Examples, but it should be understood that_{'} the invention is not limited thereto. Unless otherwise noted, all the percents are given by weight.

### EXAMPLE 1

### 1) Preparation of titanium dioxide-containing coating composition

A titanium dioxide dispersion having a titanium dioxide concentration of 11% was prepared in the same manner as described in Barbe, *Journal of American Ceramic Society,* vol. 80, p. 3157, except that the autoclave temperature was set at 230°C. The dispersed titanium dioxide particles had an average particle size of about 10 nm. To the dispersion was added 30%, based on the titanium dioxide, of polyethylene glycol (molecular weight: 20, 000; a product of Wako Pure Chemical) to prepare a coating composition.

### 2) Preparation of dye-sensitized TiO₂ electrode

Electrically conductive glass having an F-doped (i.e., a fluorine-doped) tin oxide coated [produced by Asahi Glass Co., Ltd.; surface resistivity: about 10 Ω/□(square)] was used as a substrate. The titanium dioxide-containing coating composition prepared in item (1) was applied to the conductor layer side of the glass substrate with a doctor blade to obtain a coating thickness of 140 µm, dried at 25°C for 30 minutes, and then baked in an electric muffle furnace (Model FP-32, manufactured by Yamato Kagaku) at 450°C for 30 minutes. The electrode layer thus formed had 15 g/m² of titanium dioxide coated (as a coating amount)and had a thickness of 10 µm.

After being cooled out of the furnace, the coated glass substrate was immersed in a 3 x 10⁻⁴ mol/l ethanol solution of the dye shown in Table 1 below for 3 hours. The pickup of the dye was selected appropriately from 0 . 1 to 10 mmol/m² according to the dye. The dyed glass substrate was then immersed in 4-t-butylpyridine for 15 minutes, washed with ethanol, and dried spontaneously to obtain a dye-sensitized TiO₂ electrode substrate (2 cm by 2 cm).

### 3) Preparation of photo-electrochemical cell

An electrolytic solution was prepared by dissolving iodine and lithium iodide in a 90/10 (by volume) mixed solvent of acetonitrile and N-methyl-2-oxazolidinone in concentrations of 0.05 mol/l and 0.5 mol/l, respectively.

As shown in Fig. 1, the electrode substrate prepared in item(2) and a Pt-deposited glass substrate of the same size (2 cm x 2 cm) were brought into contact with the electrode layer 3 and the Pt deposit layer 6 facing each other. The electrolytic solution was introduced into the gap between the glass substrates by making use of capillarity so as to penetrate into the TiO₂ electrode. There was thus obtained a photo-electrochemical cell composed of, in sequence, a conductive glass substrate (glass 1 having a conductor layer 2), a TiO₂ electrode 3, a dye layer 4, an electrolytic solution 5, a Pt layer 6, and glass 7.

### 4) Measurement of photoelectric conversion wavelength and photoelectric conversion efficiency

Photoelectric conversion performance of the photoelectric conversion device prepared above was measured with an IPCE (incident photon to current conversion efficiency) measuring apparatus manufactured by OPTEL CO., LTD. The wavelength at which the photo-electrochemical cell shows its maximum conversion and the photoelectric conversion efficiency at monochromatic light having that wavelength are shown in Table 1.

**TABLE 1**

| Dye | Max. Conversion Wavelength (nm) | Conversion Efficiency at Max. Conversion Wavelength (%) |
|---|---|---|
| S-1 | 490 | 80 |
| S-2 | 480 | 77 |
| S-3 | 500 | 68 |
| S-4 | 520 | 65 |
| S-5 | 540 | 64 |
| S-6 | 480 | 70 |
| S-7 | 490 | 72 |
| S-8 | 490 | 68 |
| S-9 | 510 | 65 |
| S-10 | 520 | 60 |
| S-11 | 540 | 70 |
| S-12 | 580 | 69 |
| S-13 | 530 | 55 |
| S-14 | 550 | 58 |
| S-15 | 650 | 49 |
| S-16 | 750 | 45 |
| S-17 | 790 | 43 |
| S-18 | 630 | 64 |
| S-19 | 650 | 70 |
| S-20 | 660 | 72 |
| S-21 | 640 | 73 |
| S-22 | 640 | 75 |
| S-23 | 720 | 68 |
| S-24 | 560 | 70 |
| S-25 | 450 | 75 |
| S-26 | 480 | 80 |
| S-27 | 460 | 75 |
| S-28 | 490 | 85 |
| S-29 | 470 | 80 |
| S-30 | 520 | 72 |

As is apparent from the results in Table 1, it is understood that every dye according to the present invention can achieve excellent photoelectric conversion characteristics.

## Claims

1. A photoelectric conversion device having semiconductor fine particles sensitized by a polymethine dye represented by formula (1): 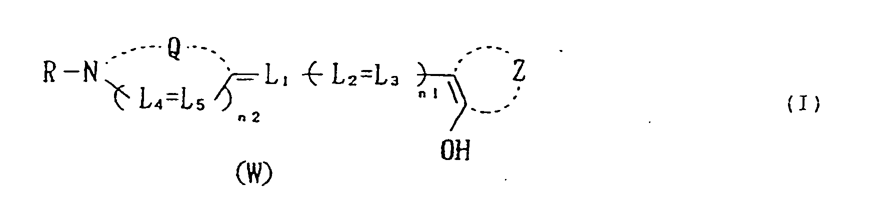
wherein Q represents an atomic group necessary to complete'a 5-or 6-membered nitrogen-containing heterocyclic ring which may be a condensed ring and may have a substitutent; L₁, L₂, L₃, L₄, and L₅ each represent a substituted or unsubstituted methine group; n₁ represents an integer of 0 to 4; n₂ represents 0 or 1; R represents a substituent; and W represents a counter ion necessary to neutralize the charge; or a polymethine dye represented by formula (II): 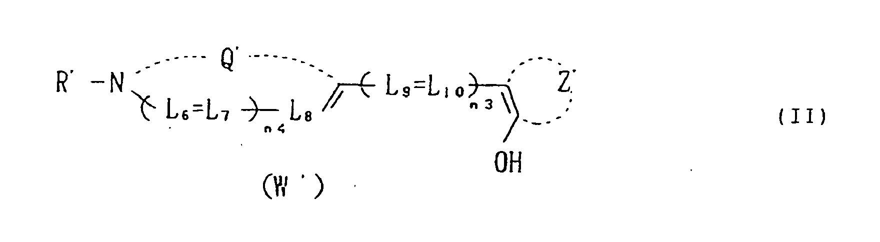 wherein Q' has the same meaning as Q; L₆, L₇, L₈, L₉, and L₁₀ each have the same meaning as L₁, L₂, L₃, L₄, and L₅ ; n₃ has the same meaning as n₁; n₄ has the same meaning as n₂; R' has the same meaning as R; and W' has the same meaning as W,
**characterised in that** the ring completed by Z or Z' is represented by formula (III) : 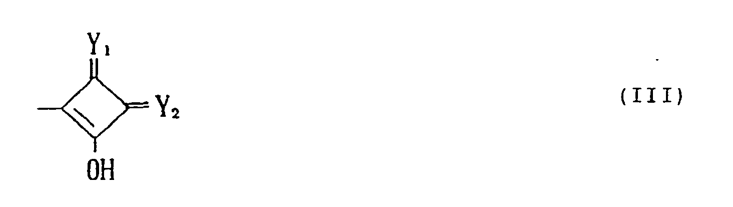
wherein Y₁ and Y₂ each represent an oxygen atom, a sulfur atom or C(CN)R''; and R" represents a cyano group, a carboxyl group, a carboxylic ester group or a carbonamido group.

2. The photoelectric conversion device as in claim 1, wherein Y₁ is an oxygen atom.

3. The photoelectric conversion device as in claim 1, wherein Y₁ and Y₂ both represent an oxygen atom.

4. The photoelectric conversion device as in claim 1, wherein the nitrogen-containing heterocyclic ring completed by Q or Q' is selected from the group consisting of an indolenine ring, a thiazoline ring, an oxazole ring, a selenazole ring, an imidazole ring, a 2-quinoline ring, a 4-quinoline ring and a condensed ring thereof having a benzene ring fused thereto.

5. The photoelectric conversion device as in claim 1, wherein said semiconductor fine particles are titanium oxide fine particles.

6. A photo-electrochemical cell comprising a photoelectric conversion device according to claim 1.

## Patentansprüche

1. Fotoelektrische Umwandlungsvorrichtung mit feinen Halbleiterteilchen, sensibilisiert durch einen Polymethinfarbstoff, wiedergegeben durch die Formel (I) 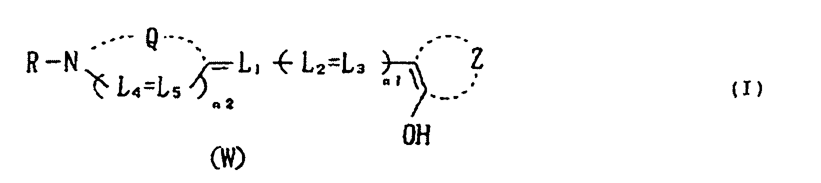
worin Q eine Atomgruppe bedeutet, die zum Vervollständigen eines 5- oder 6-gliedrigen Stickstoff enthaltenden heterocyclischen Rings notwendig ist, der einen kondensierten Ring haben kann und einen Substituent haben kann; L₁, L₂, L₃, L₄ und L₅ jeweils eine substituierte oder unsubstituierte Methingruppe bedeuten; n₁ eine ganze Zahl von 0 bis 4 bedeutet; n₂ 0 oder 1 bedeutet; R einen Substituent bedeutet; und W ein Gegenion bedeutet, das zum Neutralisieren der Ladung notwendig ist;
oder durch einen Polymethinfarbstoff, wiedergegeben durch die Formel (II): 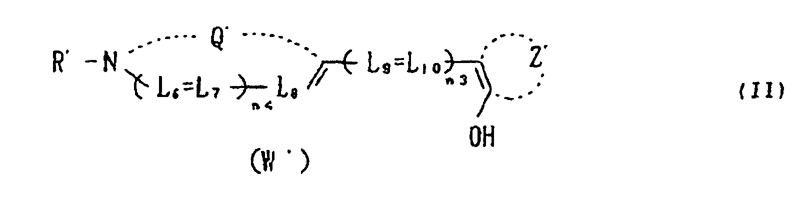
wherein Q' die gleiche Bedeutung hat wie Q; L₆, L₇, L₈, L₉ und L₁₀ jeweils die gleiche Bedeutung haben wie L₁, L₂, L₃, L₄ und L₅; n₃ die gleiche Bedeutung hat wie n₁; n₄ die gleiche Bedeutung hat wie n₂; R' die gleiche Bedeutung hat wie R; und
W' die gleiche Bedeutung hat wie W,
**dadurch gekennzeichnet, dass** der durch Z oder Z' vervollständigte Ring durch die Formel (III) wiedergegeben wird: 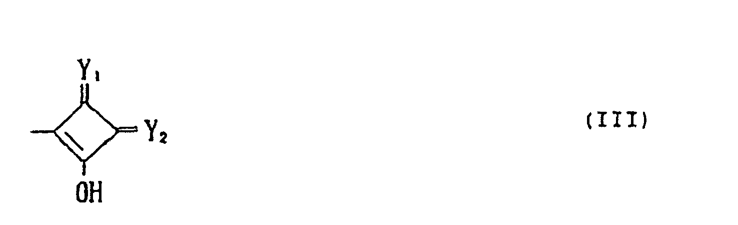
worin Y₁ und Y₂ jeweils ein Sauerstoffatom, ein Schwefelatom oder C(CN)R" bedeuten; und R" eine Cyangruppe, eine Carboxylgruppe, eine Carbonsäureestergruppe oder eine Carbonamidogruppe bedeutet.

2. Fotoelektrische Umwandlungsvorrichtung wie in Anspruch 1, worin Y₁ ein Sauerstoffatom ist.

3. Fotoelektrische Umwandlungsvorrichtung wie in Anspruch 1, worin Y₁ und Y₂ beide ein Sauerstoffatom bedeuten.

4. Fotoelektrische Umwandlungsvorrichtung wie in Anspruch 1, worin der Stickstoff enthaltende heterocyclische Ring, vervollständigt durch Q oder Q', ausgewählt ist aus der Gruppe bestehend aus einem Indoleninring, einem Thiazolinring, einem Oxazolring, einem Selenazolring, einem Imidazolring, einem 2-Chinolinring, einem 4-Chinolinring und einem kondensierten Ring davon mit einem daran kondensierten Benzolring.

5. Fotoelektrische Umwandlungsvorrichtung wie in Anspruch 1, worin die feinen Halbleiterteilchen feine Titanoxidteilchen sind.

6. Fotoelektrochemische Zelle, umfassend eine fotoelektrische Umwandlungsvorrichtung gemäß Anspruch 1.

## Revendications

1. Dispositif de conversion photoélectrique ayant de fines particules de semi-conducteur sensibilisées par un colorant en polyméthine représenté par la formule (I) : 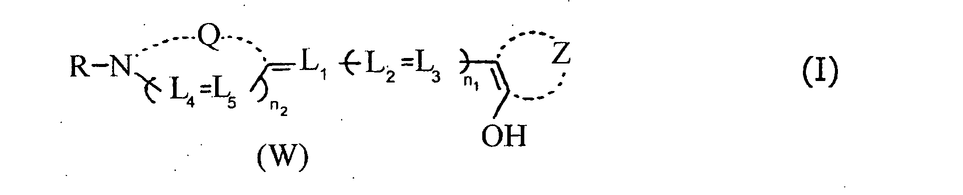
dans laquelle Q représente un groupe atomique nécessaire pour compléter un cycle hétérocyclique à 5 ou 6 éléments contenant de l'azote lequel peut être un cycle condensé et peut avoir un substituant ; L₁, L₂, L₃, L₄ et L₅ représentent chacun un groupe méthine substitué ou non substitué ; n₁ représente un nombre entier valant 0 à 4 ; n₂ représente 0 ou 1 ; R représente un substituant ; et W représente un contre-ion nécessaire pour neutraliser la charge ; ou un colorant en polyméthine représenté par la formule (II) : 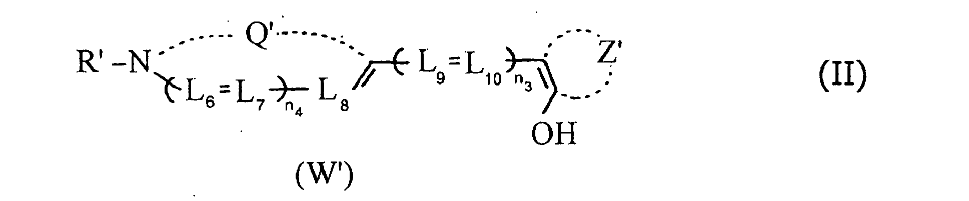
dans laquelle Q' a la même signification que Q ; L₆, L₇, L₈, L₉ et L₁₀ ont chacun la même signification que L₁, L₂, L₃, L₄ et L₅ ; n₃ a la même signification que n₁ ; n₄ a la même signification que n₂ ; R' a la même signification que R ; et W' a la même signification que W,
**caractérisé en ce que** le cycle complété par Z ou Z' est représenté par la formule (III) : 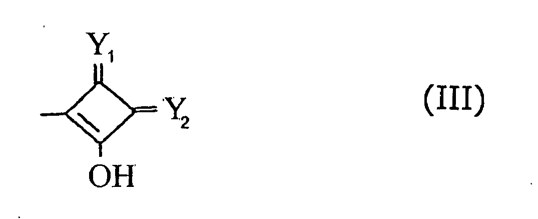
dans laquelle Y₁ et Y₂ représentent chacun un atome d'oxygène, un atome de soufre ou C(CN)R" ; et R" représente un groupe cyano, un groupe carboxyle, un groupe ester carboxylique ou un groupe carbonamido.

2. Dispositif de conversion photoélectrique selon la revendication 1, dans lequel Y₁ est un atome d'oxygène.

3. Dispositif de conversion photoélectrique selon la revendication 1, dans lequel Y₁ et Y₂ représentent tous deux un atome d'oxygène.

4. Dispositif de conversion photoélectrique selon la revendication 1, dans lequel le cycle hétérocyclique contenant de l'azote complété par Q ou Q' est choisi dans le groupe constitué d'un cycle indolénine, d'un cycle thiazoline, d'un cycle oxazole, d'un cycle sélénazole, d'un cycle imidazole, d'un cycle 2-quinoléine, d'un cycle 4-quinoléine et d'un cycle condensé de ceux-ci ayant un cycle benzène fusionné à ceux-ci.

5. Dispositif de conversion photoélectrique selon la revendication 1, dans lequel lesdites fines particules de semi-conducteur sont des fines particules d'oxyde de titane.

6. Pile photoélectrochimique comprenant un dispositif de conversion photoélectrique selon la revendication 1.
